# DEMANDE DE BREVET EUROPEEN

(11) **EP 0 538 092 A1**
(43) Date de publication de la demande: **21.04.1993**
(21) Numéro de dépôt: 92402709.7
(22) Date de dépôt: 05.10.1992
(51) Int. Cl.: B01J 15/00, C23C 16/44, C23F 4/00

(54) **Réacteur de traitement chimique en phase gazeuse**

(30) Priorité: 07.10.1991 FR 9112316
(71) Demandeur: COMMISSARIAT A L'ENERGIE ATOMIQUE, F-75015 Paris (FR)
(72) Inventeur: Arena, Chantal, F-38120 Le Fontanil (FR); Joly, Jean-Pierre, F-38120 Saint Egreve (FR); Noel, Patrice, F-38360 Sassenage (FR); Papapietro, Michel, F-69006 Lyon (FR)
(74) Mandataire: Dubois-Chabert, Guy

(57) **Abrégé**

L'invention concerne un réacteur de traitement chimique en phase gazeuse de plaquettes.

Le but de l'invention est de réaliser un réacteur dans lequel, seule la face à traiter de la plaquette soit effectivement traitée.

Le but est atteint à l'aide d'un réacteur comprenant au moins une chambre de traitement (19) prévue à l'intérieure d'une chambre principale (9) et reliée à l'une de ses extrémités à des moyens (17) pour injecter un gaz de traitement sur une plaquette (1) et à son autre extrémité à des moyens de maintien (15) de ladite plaquette, en ce que la plaquette (1) est pincée entre une sole de chauffage (13) et les moyens de maintien (15) de façon à fermer ladite chambre de traitement (19) et à maintenir à l'intérieur de celle-ci, une pression inférieure à celle de la chambre principale (9).

L'invention concerne plus particulièrement les réacteurs de dépôt de tungstène sur des plaquettes de silicium.

## Description

La présente invention concerne un réacteur de traitement chimique en phase gazeuse permettant notamment de réaliser un dépôt chimique en phase vapeur, (connu sous la terminologie anglaise CVD), sur des plaquettes de silicium, par exemple. Le réacteur permet également de réaliser des traitements chimiques pour la gravure de ces plaquettes.

En effet, lors de la fabrication de circuits intégrés sur des plaquettes de silicium, on dépose sur celles-ci, divers matériaux, grâce à des procédés physico-chimiques variés utilisant des réacteurs appropriés. Le réacteur selon l'invention permet justement de déposer sur lesdites plaquettes, divers matériaux et notament le tungstène qui est un matériau dont l'utilisation est délicate.

De très nombreuses sociétés américaines telles que par exemple Applied Materials, Genus, Novellus et Varian fabriquent et commercialisent des réacteurs dédiés au dépôt CVD du tungstène. Toutefois, la plupart de ces réacteurs présentent un certain nombre d'inconvénients.

Les dépôts CVD s'effectuent entre 300 et 600°C, ce qui nécessite le chauffage de la plaquette de silicium à traiter. Ce chauffage peut être effectué par plusieurs techniques.

Premièrement, la plaquette peut être chauffée directement par les radiations de lampes appropriées qui sont placées derrière une fenêtre transparente aux radiations. Toutefois, celle-ci doit être protégée des dépôts métalliques se produisant dans la chambre, afin de conserver sa transparence. Ceci est parfois difficile à réaliser. En outre, lorsque le chauffage est réalisé par des lampes, le support de la plaquette doit présenter une surface très limitée pour ne pas ombrer celle-ci. En conséquence la plaquette "baigne" totalement dans les gaz réactifs, ce qui entraîne les dépôts souhaités sur sa face à traiter, dite face avant, mais également sur ses rebords et sa face arrière, ce qui est à éviter. En conséquence, si un dépôt survient là où il ne doit pas être effectué, il est nécessaire de prévoir des étapes supplémentaires de nettoyage pour l'enlever. Ces étapes de nettoyage demandent un certain temps et font chuter les rendements de production, ce qui peut être couteux. Par ailleurs, ces dépôts supplémentaires entraînent le gaspillage de produits chimiques de gravure chers, tels que le NF₃ utilisé pour graver le tungstène, ( ceci est le cas dans les réacteurs fabriqués par Applied Materials).

Deuxièmement, le chauffage de la plaquette peut être réalisé par le contact thermique avec une sole chauffante. Cette sole peut elle-même être chauffée, soit par des lampes (cas des réacteurs de Applied Materials), soit par une résistance chauffante prévue dans la masse de la sole (cas des réacteurs fabriqués par les sociétés Genus et Novellus).

Le chauffage de la plaquette de silicium par l'intermédiaire d'une sole entraîne généralement de mauvais échanges thermiques entre la plaquette et la sole, si cette plaquette est simplement posée sur la sole. Pour améliorer ces échanges thermiques, certains réacteurs sont munis de moyens permettant de réaliser le vide entre la plaquette et la sole afin d'améliorer le contact physique entre ces deux éléments et donc la conduction thermique. Toutefois, ces techniques de vide présentent l'inconvénient d'attirer les gaz vers la face arrière de la plaquette, et vers ses rebords en y entraînant des dépôts qui sont justement à éviter. Dans le réacteur fabriqué par la société Novellus, on propose de faire le vide sur les trois quarts de la plaquette en face arrière et de souffler un gaz sur le quart extérieur restant de celle-ci. Toutefois, cette solution ne préserve que très peu le bord de la plaquette.

Dans le cas du réacteur fabriqué par la société Genus, la plaquette est maintenue sur sa circonférence extérieure par un anneau de maintien qui plaque fermement celle-ci sur la surface de la sole chauffante afin d'améliorer la conduction thermique. Si cette technique peut permettre de protéger la face arrière de la plaquette, elle permet difficilement d'en protéger le bord périphérique.

En outre, les constructeurs proposant des systèmes munis d'une sole chauffante ont à faire face à la nécessité de nettoyer celle-ci puisqu'en tant que source de chaleur, elle est forcément plus chaude que la plaquette à traiter et que lorsqu'elle est en contact avec des gaz réactifs, elle reçoit des dépôts sur sa surface. Lorsque les dépôts de matériaux adhérent sur la sole, le nettoyage de celle-ci est souvent long et compliqué et nécessite l'emploi de substances de nettoyage qui sont parfois peu compatibles avec le matériau de la sole ou qui peuvent même attaquer la surface de celle-ci.

Ainsi dans le cas du réacteur fabriqué par la Société Varian, la sole réalisée en carbure de silicium risque d'être attaquée par les produits fluorés servant à nettoyer les dépôts qui se sont accumulés à sa surface.

Si les dépôts ne sont pas adhérents sur la sole, ce qui est la cas en particulier des dépôts de tungstène sur la plupart des matériaux du type isolant, ces dépôts en se décollant génèrent des particules métalliques qui peuvent se redéposer sur les circuits à réaliser sur la plaquette, en créant ainsi des défauts.

Enfin, les gaz utilisés pour les traitements (dépôts CVD, gravures) sont généralement des gaz très coûteux, ce qui est le cas par exemple du fluorure de tungstène et du fluorure d'azote (WF₆ et NF₃). En conséquence, il serait souhaitable de diminuer le plus possible le volume de la chambre de traitement tout en augmentant l'efficacité de la réaction sur la plaquette. Actuellement, le plus petit volume d'une chambre existant est de 1 l pour traiter une plaquette.

L'invention a donc pour but de remédier à ces inconvénients, c'est-à-dire de réaliser un réacteur permettant des traitements chimiques en phase vapeur et notamment le dépôt de matière sur la face à traiter (dite face avant) de la plaquette tout en évitant les dépôts sur la face arrière et le rebord périphérique de celle-ci. En effet, ces deux parties ne sont généralement pas recouvertes au préalable d'une couche d'adhérence pour le dépôt des matériaux, notamment le tungstène, ce qui donne lieu à des dépôts qui se décollent, en produisant des particules qui ont tendance à se coller sur les circuits et à les détruire.

A cet effet, l'invention concerne un réacteur de traitement chimique en phase gazeuse d'au moins une plaquette présentant une face à traiter et une face à protéger, ce réacteur comprenant une chambre principale maintenue à une première pression, à l'intérieur de laquelle sont disposés ladite plaquette, une sole de chauffage de ladite plaquette, des moyens de maintien de cette plaquette et des moyens pour injecter le gaz de traitement sur la face à traiter de ladite plaquette.

Selon les caractéristiques de l'invention, ce réacteur comprend au moins une chambre de traitement définie par ses parois latérales, cette chambre de traitement étant prévue à l'intérieur de la chambre principale et étant reliée à l'une de ses extrémités, aux moyens pour injecter le gaz de traitement et à son autre extrémité aux moyens de maintien, en ce que la plaquette est pincée entre la sole de chauffage et les moyens de maintien de façon que ceux-ci reposent sur la périphérie de la face à traiter, afin que la plaquette ferme ladite chambre de traitement et en ce qu'il règne à l'intérieur de cette chambre de traitement, une deuxième pression inférieure à la pression de la chambre principale.

Ainsi, on réalise une chambre de traitement à l'intérieur de la chambre principale, cette chambre de traitement étant fermée à l'une de ses extrémités par la plaquette à traiter. De plus, la pression à l'intérieur de la chambre principale étant supérieure à la pression dans la chambre de traitement, les gaz traitants ne peuvent réagir et notamment se déposer dans la chambre principale, dans le cas d'un traitement de type dépôt. Ces deux caractéristiques permettent d'une part de limiter efficacement le traitement à la face avant de ladite plaquette et d'autre part de protéger également la sole chauffante se trouvant dans la chambre principale, de ces traitements éventuels (dépôts ou gravures).

De façon avantageuse, la sole de chauffage est munie de moyens moteurs permettant de la déplacer axialement par rapport aux moyens de maintien. De préférence, ces moyens sont des vérins. Ceci permet de pincer efficacement la plaquette à traiter entre la sole et lesdits moyens de maintien et également de pouvoir retirer très rapidement cette plaquette lorsque le traitement est terminé.

Selon une caractéristique avantageuse de l'invention, les moyens de maintien de la plaquette à traiter sur la sole de chauffage sont constitués par un anneau plat. Lorsqu'il est en place, cet anneau repose sur la périphérie de la face à traiter de la plaquette en forme de disque. Or, les plaquettes ont généralement subi des étapes de traitement préalable au cours desquelles des marques ont été laissées par des pinces (ou anneaux de pincement) sur la périphérie des plaquettes. En conséquence, à ces endroits le dépôt CVD risque de ne pas adhérer et d'entraîner les inconvénients précédemment cités. La présence de l'anneau de maintien sur la périphérie de la plaquette permet justement de masquer ces marques et d'éviter les dépôts à ces endroits.

En outre, les moyens de maintien de la plaquette sont montés sur les parois latérales de la chambre de traitement de façon amovible.

On peut ainsi réaliser l'anneau de maintien dans divers matériaux et utiliser celui qui sera le mieux adapté en fonction des applications et des gaz de traitement, utilisés. C'est ainsi, que l'anneau de maintien peut être réalisé dans des matériaux permettant un bon isolement thermique ou électrique (par exemple l'alumine) ou dans un matériau catalyseur de la réaction chimique réalisée dans le réacteur (on utilisera dans ce cas un métal, par exemple).

En outre, selon une autre caractéristique avantageuse de l'invention, les moyens pour injecter le gaz de traitement, prévus à l'une des extrémités de la chambre de traitement, sont montés sur des moyens moteurs permettant de les déplacer à l'intérieur de cette chambre de traitement afin de faire varier le volume intérieur de ladite chambre. Ainsi, et contrairement aux dispositifs de l'art antérieur, on peut adapter le volume de la chambre de traitement et notamment diminuer celui-ci lorsque les gaz de traitement utilisés sont coûteux.

En outre, de façon avantageuse, ces moyens moteurs sont refroidis par un circuit dans lequel circule un fluide de refroidissement. Ceci est intéressant notamment pour les réacteurs de traitement haute température.

Selon une caractéristique de l'invention, l'anneau de maintien peut comprendre intérieurement une résistance chauffante et/ou les parois latérales de la chambre de traitement peuvent comprendre intérieurement un circuit de refroidissement. Ceci permet de réaliser des variations thermiques à l'intérieur de la chambre de traitement et d'éviter par exemple le dépôt de matière sur les parois latérales de la chambre de traitement.

Enfin, la chambre principale peut comprendre au moins deux chambres de traitement, ces chambres de traitement permettant le traitement simultané d'au moins deux plaquettes.

L'invention sera mieux comprise à la lecture de la description suivante d'un mode de réalisation préférentiel donné à titre d'exemple illustratif, cette description étant faite en faisant référence aux dessins joints dans lesquels :
- La figure 1 représente une coupe de côté du réacteur de traitement chimique selon l'invention,
- La figure 2 représente une vue agrandie et en coupe partielle d'une partie de ce réacteur, et
- La figure 3 est une vue schématique en perspective illustrant un second mode de réalisation de l'invention.

Pour plus de clarté dans la description, celle-ci se réfère à un réacteur de dépôt. Toutefois, le réacteur selon l'invention peut être utilisé pour d'autres types de traitements et notamment pour la gravure.

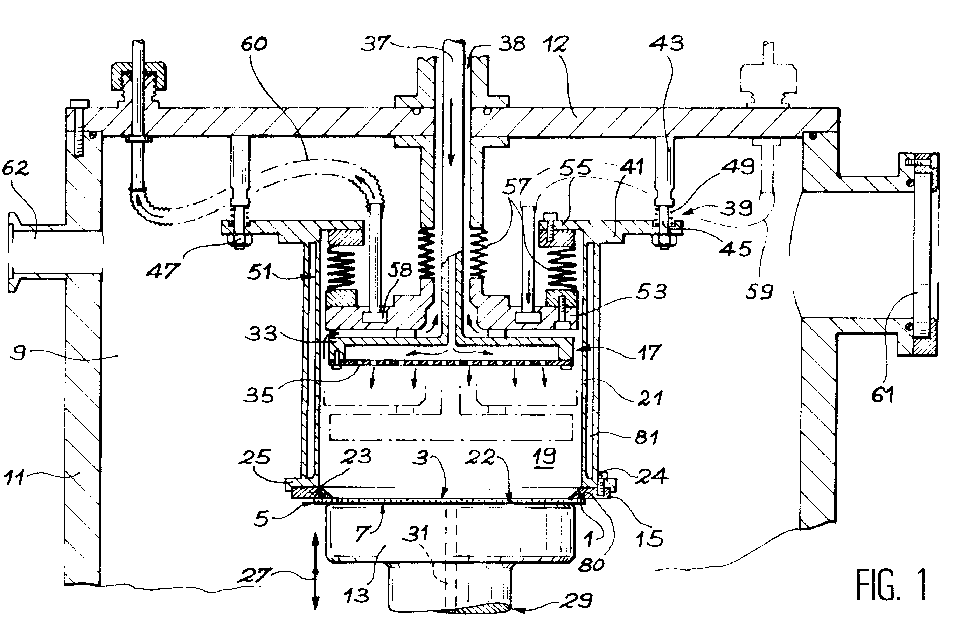

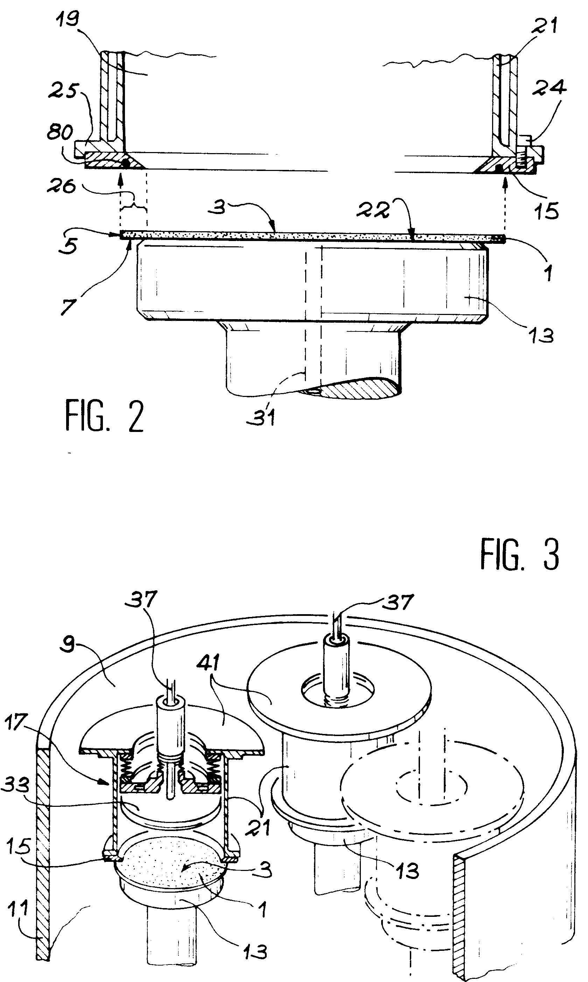

Comme illustré sur les figures 1 et 2, le réacteur de traitement chimique selon l'invention permet de réaliser des dépôts en phase vapeur sur une plaquette 1 présentant une face à traiter 3, un rebord périphérique 5 et une face 7 à protéger des dépôts, dite également face arrière.

De façon classique, ce réacteur comprend une chambre principale 9 délimitée par des parois latérales 11 et une paroi supérieure 12 et à l'intérieur de laquelle règne une première pression P₁.

La plaquette à traiter 1 est disposée à l'intérieur de la chambre principale 9 entre une sole de chauffage 13 et des moyens de maintien 15. On prévoit également à l'intérieur de la chambre 9 des moyens 17 pour injecter le gaz de traitement sur la surface à traiter 3 de la plaquette 1.

Selon les caractéristiques de l'invention, la chambre principale 9 comprend intérieurement au moins une chambre de traitement 19 définie par ses parois latérales 21, cette chambre de traitement étant reliée à l'une de ses extrémités aux moyens 17 permettant l'injection d'un gaz et à son autre extrémité aux moyens de maintien 15 de la plaquette.

La plaquette à traiter 1 ayant généralement la forme d'un disque, il s'ensuit que de préférence, la sole de chauffage 13 présente une surface supérieure 22 circulaire, les parois latérales 21 de la chambre de traitement 19 sont cylindriques et les moyens de maintien 15 sont formés par un anneau plat présentant un bord intérieur 23 biseauté. Ces formes circulaires ou cylindriques ne sont pas limitatives de l'invention. Cet anneau 15 est fixé de façon amovible au moyen de plusieurs vis 24, à un rebord périphérique annulaire 25 s'étendant radialement à la base des parois 21 de ladite chambre de traitement.

Lors de l'utilisation, et comme cela est représenté en figure 1, la plaquette 1 est pincée entre la sole de chauffage 13 et l'anneau de maintien 15. Ce dernier repose sur la périphérie annulaire 26 (voir figure 2) de la face à traiter 3 de ladite plaquette. Ladite plaquette ferme alors la chambre de traitement 19, et il est donc possible de faire régner à l'intérieur de celle-ci une pression P₂ inférieure à la pression P₁ régnant dans la chambre principale 9.

En outre, le fait que l'anneau de maintien 15 repose sur la périphérie extérieure 26 de la face à traiter 3 en masquant celle-ci est intéressant dans la mesure où cette partie est protégée de dépôts éventuels comme cela à été expliqué précédemment.

Enfin, il est possible de prévoir un système de régulation thermique dans l'anneau 15 et dans les parois latérales 21. On peut ainsi compenser les pertes thermiques dues au contact anneau/plaquette en prévoyant par exemple une résistance chauffante 80 brasée dans l'anneau 15 et/ou on peut refroidir les parois latérales 21 pour y éviter les dépôts en prévoyant dans l'épaisseur de celles-ci un circuit de refroidissement 81 adéquat. Il est ainsi possible de limiter les dépôts indésirés sur la face intérieure des parois 21 et donc d'augmenter le temps d'utilisation du réacteur avant d'avoir à le nettoyer.

Afin que la plaquette à traiter puisse être installée ou retirée facilement de la chambre de traitement 19, ladite sole de chauffage 13 est munie de moyens moteur 27 permettant de la déplacer axialement dans la direction de l'anneau de maintien 15 ou dans le sens opposé. De préférence, ces moyens moteurs sont constitués par des vérins (ceux-ci sont simplement schématisés en figure 1).

Selon une variante de réalisation, il est possible de prévoir à l'intérieur de la sole de chauffage 13 des moyens 29 pour injecter un gaz de bonne conductibilité thermique, entre la face supérieure 22 de la sole de chauffage 13 et la face arrière 7 de la plaquette à traiter 1. Ces moyens 29 comprennent une canalisation 31 traversant ladite sole chauffante. Le gaz est injecté à une presion P₃ suffisante pour optimaliser les échanges thermiques entre ladite sole 13 et la plaquette 1. Cette injection de gaz est possible dés que la plaquette est en contact avec l'anneau 15.

La combinaison des pressions P₂ et P₃ respectivement à l'intérieur de la chambre de traitement 19 et sous la plaquette 1 est particulièrement bien adaptée aux cas des dépôts sous haute pression. En effet, la différence entre les pressions P₂ et P₃ (P₂ > P₃) se conjugue avec l'effet mécanique de pression des moyens de maintien 15 pour maintenir la plaquette 1 en contact étroit avec la sole de chauffage 13. On améliore ainsi l'efficacité des échanges thermiques entre la sole et la plaquette et on évite les déformations convexes de la plaquette, la décollant de la sole.

Les moyens 17 pour injecter le gaz de traitement comprennent un injecteur de gaz 33 muni de perforations 35 et alimenté par une canalisation 37 au travers de laquelle est amené le gaz de traitement maintenu à la pression P₂. Ce gaz est évacué de la chambre de traitement 19 par une canalisation 38 coaxiale à la canalisation 37 et débouchant à la partie supérieure de la chambre principale.

La partie supérieure des parois latérales 21 définissant la chambre de traitement 19 est reliée à la paroi supérieure 12 de la chambre principale 9 par des moyens d'amortissement 39. Ces moyens d'amortissement permettent de compenser les différences d'assiette entre la sole de chauffage 13 et l'anneau de maintien 15.

Plus précisément, la partie supérieure des parois latérales 21 de la chambre de traitement est munie d'un rebord annulaire 41 s'étendant radialement vers l'extérieur sensiblement parallèmement à la paroi 12 de la chambre principale. Une pluralité d'axes 43 (deux seulement sont représentés en figure 1) s'étendent à l'intérieur de la chambre 9 depuis la paroi 12. Chaque axe 43 présente à son extrémité une tige 45 de plus faible diamètre, traversant le rebord 41. L'extrémité de la tige est filetée de façon à recevoir un boulon 47 permettant la fixation du rebord 41 et donc la suspension de la totalité de la chambre de traitement 19 et des moyens 17 d'injection de gaz sur la paroi supérieure 12 du réacteur.

Afin de réaliser l'amortissement (moyens 39), un ressort à boudin 49 est disposé autour de la tige 45 et est maintenu à ses deux extrémités respectivement par l'axe 43 et par le rebord 41.

Selon une variante de réalisation, les moyens 17 pour injecter un gaz de traitement sur la plaquette 1 peuvent être montés sur des moyens 51 de déplacement permettant de déplacer axialement l'injecteur 33 à l'intérieur de la chambre de traitement 19. Plus précisément, l'injecteur 33 est montés sur une plaque support 53, tandis que la partie supérieure des parois latérales 21 présente un prolongement annulaire 55 s'étendant radialement vers l'intérieur et disposé en face du rebord 41. Une pluralité de soufflets ou de ressorts 57 sont fixés entre le prolongement 55 et la plaque support 53. Sous l'action de pistons ou vérins (non représentés en figure 1), l'injecteur 33 peut se déplacer axialement à l'intérieur de la chambre de traitement 19, entre une position supérieure (représentée an traits pleins en figure 1) et une position inférieure (représentée en traits mixtes). On peut ainsi faire varier le volume de la chambre de traitement et atteindre par exemple un volume de 0,5 1, ce qui est assez faible comparé à l'art antérieur.

De façon avantageuse, la plaque support 53 comporte intérieurement un circuit de refroidissement 58 relié à une canalisation d'entrée 59 de fluide de refroidissement et à une canalisation d'évacuation 60.

On notera que les canalisations d'évacuation et d'entrée sont souples de façon à pouvoir suivre le mouvement de déplacement axial.

Enfin, le réacteur comprend des moyens pour injecter un gaz sous pression P₁ à l'intérieur de la chambre principale 9, (arrivée par la canalisation 62) et des moyens de pompage de ce gaz (non représentés).

Le réacteur peut également comprendre un hublot 61 de visualisation.

Un exemple de réalisation de l'invention va maintenant être décrit.

### EXEMPLE 1 :

Un réacteur de traitement chimique basé selon le principe de l'invention consistant à avoir au moins une chambre de traitement fermée à l'intérieur d'une chambre principale a été réalisé. Ce réacteur a permis de réaliser un dépôt de tungstène dans les conditions suivantes :

| | |
|---|---|
| - Pression P₁ à l'intérieur de la chambre principale 9 : | 100 Torrs (1,33.10⁴Pa) |
| - gaz injecté dans la chambre principale : | hydrogène, |
| - Pression P₂ à l'intérieur de la chambre de traitement 19 : | 80 Torrs (1,06.10⁴Pa) |
| - gaz injecté : | mélange d'hydrogène et de fluorure de tungstène. |
| - Pression P₃ du gaz injecté par les moyens 29 : | 10 Torrs (1,3.10³Pa) |
| - gaz injecté : | hydrogène, |

L'objectif principal de l'invention a été atteint puisque l'on a pu réaliser le'dépôt de tungstène uniquement sur la surface 3 exposée de la plaquette 1, et que les dépôts parasites sur les rebords 5 et la surface inférieure 7 ont été totalement évités.

Enfin, il est également posible selon une seconde variante de réalisation de prévoir à l'intérieur d'un unique chambre principale 9, une pluralité de chambres de traitement 19 et autant de soles de chauffage 13, de moyens de maintien et de moyens d'injection de gaz permettant de traiter ainsi autant de plaquettes 1. La figure 3 est un schéma illustrant cette seconde variante de réalisation.

## Revendications

1. Réacteur de traitement chimique en phase gazeuse d'au moins une plaquette (1) présentant une face à traiter (3) et une face à protéger (7), ce réacteur comprenant une chambre principale (9) maintenue à une première pression (P₁), à l'intérieur de laquelle sont disposés ladite plaquette (1), une sole (13) de chauffage de ladite plaquette, des moyens (15) de maintien de cette plaquette et des moyens (17) pour injecter le gaz de traitement sur la face à traiter (3) de ladite plaquette, caractérisé en ce qu'il comprend au moins une chambre de traitement (19) définie par ses parois latérales (21), cette chambre de traitement (19) étant prévue à l'intérieur de la chambre principale (9) et étant reliée à l'une de ses extrémités aux moyens (17) pour injecter le gaz de traitement et à son autre extrémité aux moyens de maintien (15), en ce que la plaquette (1) est pincée entre la sole de chauffage (13) et les moyens de maintien (15) de façon que ceux-ci reposent sur la périphérie de la face à traiter (3), afin que la plaquette (1) ferme ladite chambre de traitement (19) et en ce qu'il règne à l'intérieur de cette chambre de traitement, une deuxième pression (P₂) inférieure à le pression (P₁) de la chambre principale (9).

2. Réacteur de traitement chimique selon la revendication 1, caractérisé en ce que la sole de chauffage (13) est munie de moyens moteurs (27) permettant de la déplacer axialement par rapport aux moyens de maintien (15).

3. Réacteur de traitement chimique selon la revendication 2, caractérisé en ce que les moyens moteurs (27) comprennent des vérins.

4. Réacteur de traitement chimique selon la revendication 1, caractérisé en ce que les moyens de maintien (15) sont constitués par un anneau plat.

5. Réacteur de traitement chimique selon la revendication 1 ou 4, caractérisé en ce que les moyens de maintien (15) sont montés sur les parois latérales (21) de façon amovible.

6. Réacteur de traitement chimique selon la revendication 1, caractérisé en ce que les moyens (17) pour injecter un gaz de traitement comprennent un injecteur (33) muni de perforations (35), cet injecteur (33) étant alimenté par une canalisation (37) d'amenée du gaz de traitement maintenu sous la deuxième pression (P₂).

7. Réacteur de traitement chimique selon les revendications 1 ou 6, caractérisé en ce que les moyens (17) pour injecter un gaz de traitement sont montés sur des moyens de déplacement (51) permettant de déplacer axialement ces moyens (17) d'injection à l'intérieur de la chambre de traitement (19) et de faire varier le volume intérieur de celle-ci.

8. Réacteur de traitement chimique selon la revendication 7, caractérisé en ce que les moyens de déplacement (51) comprennent des soufflets (57) associés à des vérins.

9. Réacteur de traitement chimique selon l'une des revendications précédentes, caractérisé en ce que la sole de chauffage (13) est munie de moyens (29) pour injecter un gaz maintenu sous une troisième pression (P₃), entre la surface supérieure (22) de ladite sole (13) et la face à protéger (7) de la plaquette (1), de façon à favoriser les échanges thermiques entre ladite sole et ladite plaquette.

10. Réacteur de traitement chimique selon la revendication 4, caractérisé en ce que l'anneau de maintien (15) comprend intérieurement une résistance chauffante (80).

11. Réacteur de traitement chimique selon l'une des revendications précédentes, caractérisé en ce que les parois latérales (21) de la chambre de traitement (19) comprennent intérieurement un circuit de refroidissement (81).

12. Réacteur de traitement chimique selon l'une des revendications précédentes, caractérisé en ce que la chambre de traitement (19) liée aux moyens de maintien (15) est reliée à la paroi supérieure (12) de la chambre principale (9) par des moyens d'amortissement (39).

13. Réacteur de traitement chimique selon la revendication 12, caractérisé en ce que lesdits moyens d'amortissement (39) comprennent des ressorts (49).

14. Réacteur de traitement chimique selon l'une des revendications précédentes, caractérisé en ce que la chambre principale (9) est munie de moyens d'injection et de pompage d'un gaz permettant de maintenir la première pression (P₁).

15. Réacteur de traitement chimique selon la revendication 7, caractérisé en ce que les moyens de déplacement (51) comprennent une plaque support (53) sur laquelle sont montés les moyens d'injection (17), cette plaque support (53) présentant intérieurement un circuit de refroidissement (58) relié à une canalisation d'entrée (59) du fluide de refroidissement et à une canalisation d'évacuation (60).
